**Europäisches Patentamt**

(19) **European Patent Office**

**Office européen des brevets**

(11) Veröffentlichungsnummer: **0 067 448**
**B1**

(12) **EUROPÄISCHE PATENTSCHRIFT**

(45) Veröffentlichungstag der Patentschrift:
**10.10.84**

(21) Anmeldenummer: **82105239.6**

(22) Anmeldetag: **15.06.82**

(51) Int. Cl.³: **H 04 B 9/00,** H 03 F 1/30

(54) **Optische Empfangsschaltung.**

(30) Priorität: **16.06.81 DE 3123919**

(43) Veröffentlichungstag der Anmeldung:
**22.12.82 Patentblatt 82/51**

(45) Bekanntmachung des Hinweises auf die Patenterteilung:
**10.10.84 Patentblatt 84/41**

(84) Benannte Vertragsstaaten:
**FR GB NL**

(56) Entgegenhaltungen:
**AT - B - 351 592**
**DE - A - 2 629 014**
**DE - B - 2 929 083**
**US - A - 4 187 421**

(73) Patentinhaber: **Siemens Aktiengesellschaft, Berlin und München Wittelsbacherplatz 2, D-8000 München 2 (DE)**

(72) Erfinder: **Seinecke, Siegfried, Dr., Kiem-Pauli-Weg 3, D-8135 Söcking (DE)**

BUNDESDRUCKEREI BERLIN

## Beschreibung

Die Erfindung bezieht sich auf eine Empfangsschaltung für die optische Datenübertragung über Lichtwellenleiter nach dem Oberbegriff des Patentanspruches 1.

Bekannte Empfangsschaltungen dieser Art (vergleiche Datenblatt MFOD 402 F der Firma Motorola Semiconductor Products Inc., Phoenix, Arizona,1979 und Datenblatt 3712 R der Firma Burr-Brown Research Corp., Tuscon, Arizona, 1978) besitzen eine von Null verschiedene untere Grenzfrequenz oder eine automatische Regelung mit einer kapazitiven Speicherung der Regelgröße. Es muß daher durch eine geeignete Codierung der zu übertragenden Information sichergestellt werden, daß das Impuls-Pausenverhältnis, gemittelt über eine von der unteren Grenzfrequenz abhängige Zeit, wenigstens annähernd konstant bleibt. Im zweiten Fall kann ein für längere Zeit gleichbleibender Signalzustand der einen Art zugelassen werden, wenn dabei die Fotodiode am Eingang der Empfangsschaltung beleuchtet wird.

Der Erfindung liegt die Aufgabe zugrunde, eine Empfangsschaltung der eingangs genannten Art so auszubilden, daß sie bei hoher Empfindlichkeit die Übertragung digitaler Informationen ohne Einschränkung hinsichtlich ihres Tastverhältnisses und der maximalen Dauer von Impulsen oder Impulspausen erlaubt, die übertragenen Signale am Ausgang weitgehend unabhängig von Schwankungen der Umgebungstemperatur und der Versorgungsspannung und von der am Ende des Lichtwellenleiters ankommenden optischen Strahlungsleistung zeitrichtig wiedergibt und monolithisch integrierbar ist. Gemäß der Erfindung weist eine solche Empfangsschaltung die Merkmale im kennzeichnenden Teil des Patentanspruches 1 auf.

Die Erfindung macht dabei von der Tatsache Gebrauch, daß sich bei einer Punkt-Zu-Punkt-Verbindung, wie beispielsweise zwischen der Zentraleinheit einer Datenverarbeitungsanlage und einem peripheren Gerät die am Empfänger ankommende Strahlungsleistung im Betrieb kaum verändert. Eine automatische Regelung erscheint daher überflüssig.

Im folgenden wird die Erfindung anhand von Schaltungsbeispielen, die in der Zeichnung dargestellt sind, näher beschrieben. Es zeigt

Fig. 1 ein Ausführungsbeispiel für die Empfangsschaltung gemäß der Erfindung,

Fig. 2 und 3 Varianten für die Einspeisung des Hilfsstroms zur Festlegung des Signalmittelwerts am Ausgang des Gegentaktverstärkers.

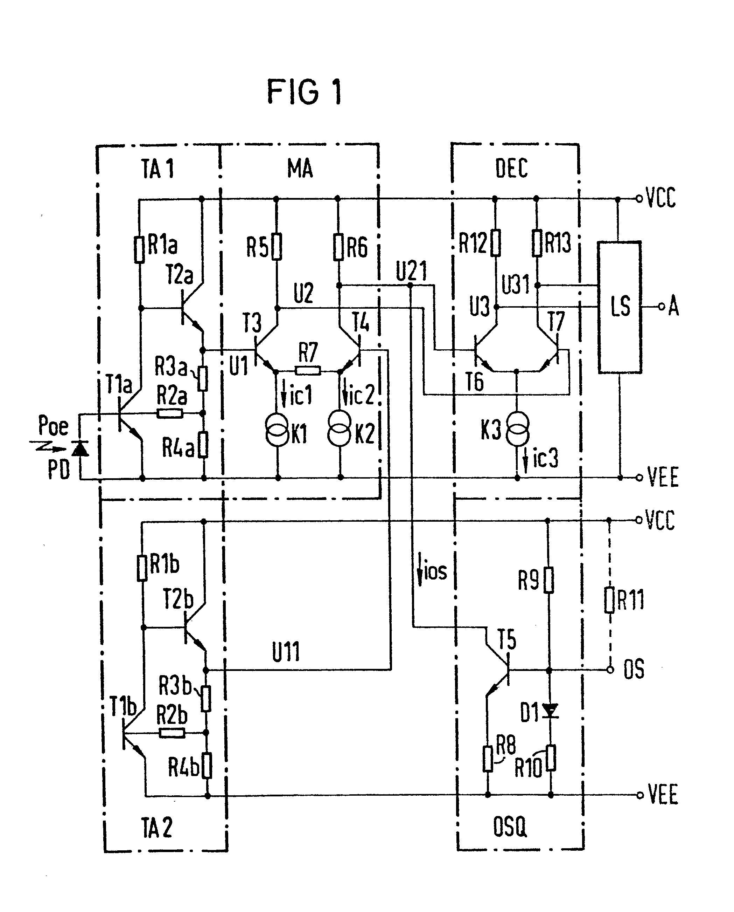

Die Fig. 1 zeigt zwei Transimpedanzverstärker TA1 und TA2 mit den Transistoren T1a und T2a bzw. T1b und T2b. Die beiden Verstärker TA1 und TA2 sind, soweit dies die Herstellungstoleranzen zulassen, gleich ausgebildet. Der einzige Unterschied besteht darin, daß am Eingang des ersten Transimpedanzverstärkers TA1 eine Fotodiode PD zur Umsetzung der optischen Strahlung in einen elektrischen Strom angeschlossen ist, während der Eingang des zweiten Verstärkers TA2 offen ist. Entgegen der Darstellung in Fig. 1 könnte aber auch am Eingang des zweiten Transimpedanzverstärkers TA2 eine entsprechende Fotodiode angeschlossen sein, die dann allerdings gegen jeglichen Lichteinfall zu schützen wäre.

Transimpedanzverstärker der in Fig. 1 gezeigten Art sind im wesentlichen durch die DE-AS 29 29 083 bekannt. Die Aufteilung des Emitterwiderstandes für den Transistor der zweiten Stufe in zwei Teilwiderstände und die Anschaltung der Basis des Transistors der ersten Stufe an den Verbindungspunkt der Teilwiderstände führte bei der bekannten Anordnung zu einer Erhöhung der Nutzspannung und zu einer Vergrößerung der Basis-Kollektorspannung am Transistor der ersten Stufe und damit zu einer Verringerung der Basis-Kollektor-Kapazität. Die genannten Maßnahmen haben darüber hinaus auch eine Anhebung des Potentials am Emitter des Transistors der zweiten Stufe zur Folge. Dies ermöglicht es im vorliegenden Fall, einen nachfolgenden linearen Gegentaktverstärker MA, dessen durch die Basisanschlüsse der Transistoren T3 und T4 gebildete Eingänge mit den Ausgängen der Transimpedanzverstärker TA1 und TA2 verbunden sind, in einem günstigen Arbeitspunkt zu betreiben.

Die Emitter der Transistoren T3 und T4 des Gegentaktverstärkers MA sind an getrennte, aber gleiche Konstantstromquellen K1 und K2 angeschlossen, welche die Ströme ic1 und ic2 liefern. Außerdem sind die Emitter über einen niederohmigen Widerstand R7 (ca. 10 Ohm bis 30 Ohm) miteinander verbunden.

Dem Strom durch den Arbeitswiderstand R6 im Kollektorkreis des Transistors T4 wird ein von einer Hilfsstromquelle OSQ erzeugter Hilfsstrom ios, im folgenden als Offsetstrom bezeichnet, überlagert. Bei entsprechender Bemessung der Stromstärke wird erreicht, daß die an den Widerständen R5 und R6 anliegenden Spannungen U2 und U21 gegenphasig mit gleicher Amplitude um den gleichen Mittelwert pendeln. Das gilt natürlich nur für eine bestimmte Anplitude und demnach auch nur für eine bestimmte, von der Fotodiode PD aufgenommene Strahlungsleistung Poe.

Die Hilfsstromquelle OSQ ist ebenso aufgebaut, wie die schon erwähnten Konstantstromquellen K1 und K2. Die Basis eines Transistors T5 mit einem Emitterwiderstand R8 ist mit einem Spannungsteiler verbunden, der aus den Widerständen R9 und R10 und aus der Diode D1 in der aus Fig. 1 ersichtlichen Weise gebildet wird. Die Diode D1 dient zum Ausgleich der Temperaturabhängigkeit der Basis-Emitterdiode des Transistors T5. Vorzugsweise werden die Widerstände R9 und R10 so bemessen, daß der Offsetstrom ios, d. h. der Kollektorstrom des Transistors T5 gerade für eine ausreichende Verschiebung der der minimalen Strahlungsleistung Poemin auf die Fotodiode PD entsprechenden Signalamplitude im Gegentaktverstärker genügt. Zur Anpassung an größere Signalhübe aufgrund höherer Strahlungsleistungen kann der Offsetstrom ios durch die Anschaltung eines zusätzlichen Widerstan des R11 zwischen der Anschlußklemme OS und dem positiven Pol VCC der Versorgungsspannung erhöht werden.

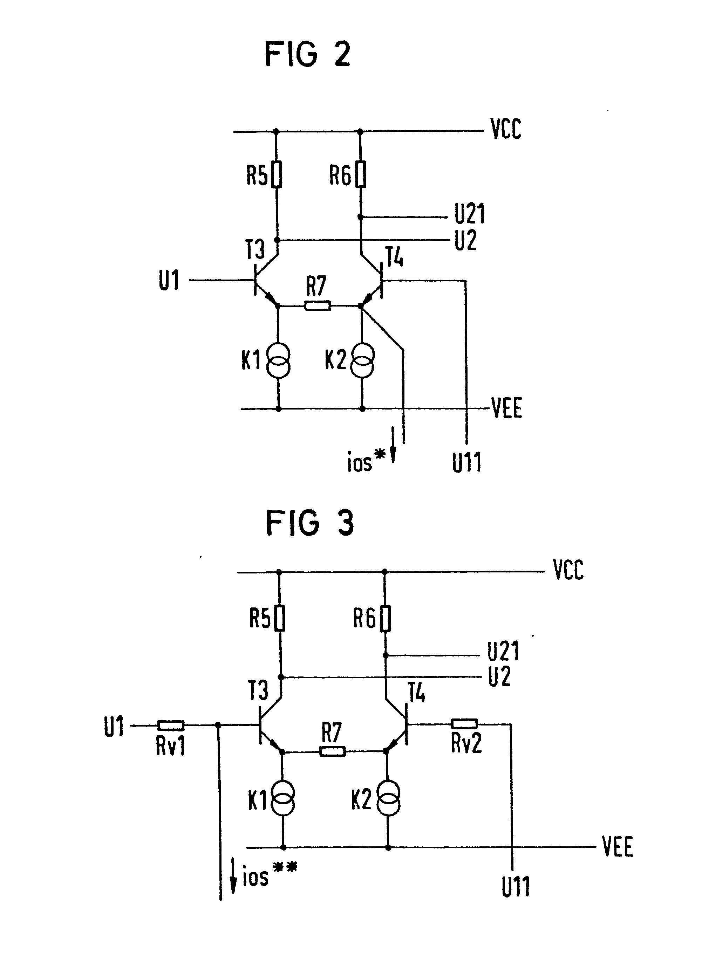

Weitere Möglichkeiten für die Einspeisung von Offsetströmen ios* bzw. ios** zeigen die Fig. 2 und 3. Nach Fig. 2 ist die Hilfsstromquelle OSQ der Konstantstromquelle K2 parallel geschaltet. Da hierbei auch ein Teil des Emitterstromes im Transistor T3 über den Widerstand R7 zur Hilfsstromquelle OSQ abfließt, muß der gesamte Offsetstrom ios* zur Erzeugung einer ausreichenden Differenz der Kollektorruheströme einen höheren Wert haben als im Ausführungsbeispiel nach Fig. 1.

Dagegen erfordert die Anordnung nach Fig. 3, wonach die Hilfsstromquelle OSQ mit der Basis des Transistors T3 verbunden ist, einen anderen Offsetstrom ios**. Der Offsetstrom ios** muß nunmehr an dem zusätzlichen, vor der Basis des Transistors T3 liegenden Vorwiderstand Rv1 einen Spannungsabfall von der Größe des halben Signalhubes erzeugen. Ein gleicher Vorwiderstand Rv2 ist dem Transistor T4 zugeordnet.

Die gemäß der zu übertragenden Information gegenphasig um den gleichen Mittelwert schwankenden Ausgangsspannungen U2 und U21 steuern einen weiteren Gegentaktverstärker DEC, der im folgenden als Entscheider bezeichnet wird und in seinem Schaltungsaufbau den Stromübernahmeschalter der bekannten ECL-Schaltungstechnik entspricht. Die Emitter der Transistoren T6 und T7 sind unmittelbar miteinander verbunden und werden durch eine Konstantstromquelle K3 mit einem Strom is3 gespeist. Die über den beiden gleichen Kollektorwiderständen R12 und R13 abgreifbaren gegenphasigen Spannungen U3 und U31 wechseln zwischen Null und einem durch das Produkt aus dem Strom ic3 und dem Wert der Kollektorwiderstände bestimmten Maximalwert von beispielsweise 0,5 V. Die vollständige Aussteuerung muß auch schon mit der minimalen optischen Eingangsleistung Poemin erfolgen.Ihre Größe ist daher durch die Empfindlichkeit der Fotodiode PD, durch die Gesamtverstärkung der Anordnung und durch die genannte Bedingung bestimmt.

Im folgenden soll dieser Wert anhand von Bemessungsbeispielen auf der Grundlage der Schaltungsanordnung nach Fig. 1 abgeschätzt werden.

Empfindlichkeit der Fotodiode PD: $iph = 0,5 [A/W] \cdot Poe$
Transimpedanzverstärker TA1: $R3a = R4a = R3b = R4b$
$R2a = R2b = 10\ k\Omega$

$$\varDelta U1 = \varDelta iph \cdot R2a \cdot \frac{R3a + R4a}{R3a} = 0,5 \cdot \varDelta Poe \cdot 10^4 \cdot 2\ [V/W].$$

Gegentaktverstärker MA: $R5 = R6 = 700\ Ohm$,
$R7 = 20\ Ohm$
$ic1 = ic2 = 3\ mA$
Verstärkung $v_{MA} \approx 16$
$\varDelta U2 = -\varDelta U21 = -\varDelta U1 \cdot v_{MA}$
$\varDelta U2 = 1,6 \cdot 10^3 \cdot \varDelta Pae\ [V/W]$
Entscheider DEC: $ic3 = 0,5\ mA$
$R12 = R13 = 1k\Omega$
$\varDelta U3 = \varDelta U31 = 0,5\ V.$

Für die Aussteuerung ist ein minimaler Signalhub $\varDelta U2 = -\varDelta U21 \approx 160\ mV$ erforderlich. Daraus errechnet sich eine minimale optische Eingangsleistung (Strahlungsleistung) Poemin = 1 µW.

Ferner ergeben sich für den Gegentaktverstärker MA bei einer Versorgungsspannung UCC = 5 V die Kollektorruhespannungen U20 = 2,9 V und U210 = 2,74 V. Um die Verschiebung der Kollektorruhespannung U210 um 160 mV zu erhalten, wird mit dem schon genannten Wert des Kollektorwiderstandes R6 = 700 Ohm ein Offsetstrom

$$iso = \frac{0,16}{700} = 0,23\ mA$$

benötigt. Die Empfindlichkeit kann durch Verwendung mehrteiliger Entscheider DEC gesteigert werden; im Grenzfall bestimmen das Fotostromrauschen, das Transistorrauschen von T1a und T1b, das Widerstandsrauschen von R2a und R2b sowie die natürlichen Offsetspannungen U1 und U11 die Untergrenze der optischen Eingangsleistung.

Um den Gegentaktsverstärker MA nicht zu übersteuern, ist die maximale optische Eingangsleistung auf ca. 10 µW begrenzt.

In Fig. 1 ist anschließend an die Entscheiderstufe DEC noch eine Funktionseinheit LS zur Signalpegelanpassung vorgesehen. Sie gibt am Ausgang A Signalpegel ab, die der TTL-Schaltungstechnik entsprechen. Demgemäß ist bei dem Ausführungsbeispiel der Versorgungsspannungsanschluß VEE geerdet. Ein Signalpegelwandler ist beispielsweise durch die US-PS 40 45 690 bekannt.

Sind die auf die Empfangsschaltung folgenden Einrichtungen zur Verarbeitung der empfangenen

3

Signale in ECL-Technik ausgebildet, dann gilt der Versorgungsspannungsanschluß VCC als Bezugspotential.

## Patentansprüche

1. Empfangsschaltung für die optische Datenübertragung über Lichtwellenleiter mit einem ersten Transimpedanzverstärker (TA1) zur Umwandlung des von einer die optischen Signale empfangenden Fotodiode (PD) gelieferten Stroms in eine Ausgangsspannung, mit einem anschließenden linearen Spannungsverstärker (MA) und mit einem Entscheider (DEC) zur Umformung der analogen in digitale Signale, dadurch gekennzeichnet, daß

a) ein zweiter, dem ersten Transimpedanzverstärker (TA1) gleicher Transimpedanzverstärker (TA2) vorgesehen ist, dessen Eingang offen ist,
b) der lineare Spannungsverstärker als Gegentaktverstärker (MA) mit zwei Transistoren (T3, T4) ausgebildet ist, deren Emitter sowohl mit je einer Konstantstromquelle (K1, K2) als auch über einen Widerstand (R7) miteinander und deren Basisanschlüsse mit den Ausgängen der Transimpedanzverstärker (TA1, TA2) verbunden sind,
c) eine Hilfsstromquelle [OSQ) dem Kollektorstrom mindestens eines Transistors (T3, T4) des Gegentaktvertärkers (MA) einen einstellbaren Hilfsstrom (ios, ios*, ios**) derart überlagert, daß die an den Kollektorwiderständen der Transistoren (T3, T4) abgreifbaren gegenphasigen Signalspannungen gleiche Amplituden und Mittelwerte aufweisen.

2. Empfangsschaltung nach Anspruch 1, dadurch gekennzeichnet, daß der Ausgang der Hilfsstromquelle (OSQ) mit dem Kollektor des von dem zweiten Transimpedanzverstärker (TA2) gesteuerten Transistors (T4) des Gegentaktverstärkers (MA) verbunden ist (Fig.1).

3. Empfangsschaltung nach Anspruch 1, dadurch gekennzeichnet, daß der Ausgang der Hilfsstromquelle (OSQ) mit dem Emitter des von dem zweiten Transimpedanzverstärker (TA2) gesteuerten Transistors (T4) des Gegentaktverstärkers (MA) verbunden ist (Fig. 2).

4. Empfangsschaltung nach Anspruch 1, dadurch gekennzeichnet, daß die Basis des einen Transistors (T3) des Gegentaktverstärkers (MA) mit dem Ausgang der Hilfsstromquelle (OSQ) und über einen Widerstand (Rv1) mit dem Ausgang des ersten Transimpedanzverstärkers (TA1) verbunden ist und daß die Basis des zweiten Transistors (T4) über einen Vorwiderstand (Rv2) gleicher Größe mit dem Ausgang des zweiten Transimpedanzverstärkers (TA2) verbunden ist (Fig.3).

## Claims

1. A receiving circuit for optical data transmission via light waveguides having a first transimpedance amplifier (TA1) for conversion of the current supplied by a photodiode (PD) receiving the optical signals into an output voltage, and followed by a linear voltage amplifier (MA) and a decision stage (DEC) for converting the analogue signals into digital signals, characterised in that

a) there is provided a second transimpedance amplifier (TA2) equal to the first transimpedance amplifier (TA1) and having an open-circuit input,
b) the linear voltage amplifier is designed as a push-pull amplifier (MA) having two transistors (T3, T4) whose emitters are respectively connected to a constant current source (K1, K2) and connected together by a resistor (R7), and whose base electrodes are connected to the outputs of the transimpedance amplifiers (TA1, TA2),
c) an auxiliary current source (OSQ) superimposes an adjustable auxiliary current (ios, ios*, ios**) on the collector current of at least one transistor (T3, T4) of the push-pull amplifier (MA) in such a manner that the antiphase signal voltages which can be tapped off from the collector resistors of the transistors (T3, T4), have the same amplitude levels and mean values.

2. A receiving circuit as claimed in Claim 1, characterised in that the output of the auxiliary current source (OSQ) is connected to the collector of the transistor (T4) of the push-pull amplifier (MA) which is controlled by the second transimpedance amplifier (TA2), (Figure 1).

3. A receiving circuit as claimed in Claim 1, characterised in that the output of the auxiliary current source (OSQ) is connected to the emitter of the transistor (T4) of the push-pull amplifier (MA) which is controlled by the second transimpedance amplifier (TA2), (Figure 2).

4. A receiving circuit as claimed in Claim 1, characterised in that the base of the one transistor (T3) of the push-pull amplifier (MA) is connected to the output of the auxiliary current source (OSQ) and via a resistor (Rv1) to the output of the first transimpedance amplifier (TA1), and that the base of the second transistor (T4) is connected via a resistor (Rv2) of equal magnitude to the output of the second transimpedance amplifier (TA2), (Figure 3).

## Revendications

1. Circuit de réception pour la transmission optique de données par l'intermédiaire de guides d'ondes de lumière comportant un premier amplificateur formant transimpédance (TA1) servant à convertir le courant délivre par une photodiode [PD) recevant les signaux optiques, en une tension de sortie, et comportant un amplificateur linéaire de tension (MA) raccordé en aval et un étage de décision (DEC) servant à transformer les signaux analogiques en signaux numériques, caractérisé par le fait que

a)  il est prévu un second amplificateur formant transimpédance (TA2) identique au premier amplificateur formant transimpédance (TA1) et dont l'en trée est ouverte,

b)  l'amplificateur linéaire de tension est réalisé sous la forme d'un amplificateur push-pull (MA) comportant deux transistors (T3, T4), dont les émetteurs sont reliés aussi bien respectivement à une source de courant constant (K1, K2) qu'entre eux par l'intermédiaire d'une résistance (R7) et dont les bornes de base sont reliées aux sorties des amplificateurs formant transimpédance (TA1, TA2),

c)  une source de courant auxiliaire (OSΩ) superpose un courant auxiliaire réglable (ios, ios*, ios**) au courant de collecteur d'au moins un transistor (T3, T4) de l'amplificateur push-pull (MA), de telle sorte que les tensions de signal en opposition de phase, pouvant être prélevées sur les résistances de collecteur des transistors (T3, T4), possédent des amplitudes identiques et des valeurs moyennes identiques.

2. Circuit de réception suivant la revendication 1, caractérisé par le fait que la sortie de la source de courant auxiliaire (OSΩ) est reliée au collecteur du transistor (T4), commandé par le second amplificateur formant transimpédance (TA2), de l'amplificateur push-pull (MA) (figure 1).

3. Circuit de réception suivant la revendication 1, caractérisé par le fait que la sortie de la source de courant auxiliaire (OSΩ) est reliée à l'émetteur du transistor (T4), commandée par le second amplificateur formant transimpédance (TA2), de l'amplificateur push-pull (MA).

4. Circuit de réception suivant la revendication 1, caractérisé par le fait que la base d'un transistor (T3) de l'amplificateur push-pull (MA) est reliée à la sortie de la source de courant auxiliaire (OSΩ) et, par l'intermédiaire d'une résistance (Rv), à la sortie du premier amplificateur formant transimpédance (TA1) et que la base du second transistor (T4) est reliée par l'intermédiaire d'une résistance additionnelle (Rv2) de même valeur à la sortie du second amplificateur formant transimpédance (TA2) (figure 3).

# FIG 1

## FIG 2

## FIG 3